# EUROPEAN PATENT APPLICATION

(11) **EP 3 780 130 A1**
(43) Date of publication of application: **17.02.2021**
(21) Application number: 18887232.9
(22) Date of filing: 29.11.2018
(51) Int. Cl.: H01L 51/50, H01L 51/56

(54) **QUANTUM DOT LIGHT-EMITTING DIODE AND MANUFACTURING METHOD THEREFOR, AND DISPLAY DEVICE**

(30) Priority: 29.03.2018 CN 201810270120
(71) Applicant: BOE Technology Group Co., Ltd., Beijing 100015 (CN)
(72) Inventor: YOU, Juanjuan, Beijing 100176 (CN)
(74) Representative: Lavoix
(86) International application number: PCT/CN2018/118115
(87) International publication number: WO 2019/184413

(57) **Abstract**

The present disclosure relates a quantum-dot light-emitting diode, a method for preparing the same, and a display device. A first electron transport layer formed of an electron transport material is arranged on a side of a quantum-dot light-emitting layer of the quantum-dot light-emitting diode proximate to a side of a hole transport layer; and/or a quantum-dot light-emitting layer of the quantum-dot light-emitting diode is doped with the electron transport material. This structure improves the injection balance between holes and electrons.

## Description

### CROSS-REFERENCE TO RELATED APPLICATION

This application claims a priority to Chinese Patent Application No. 201810270120.1 filed on March 29, 2018, the disclosures of which are incorporated in their entirety by reference herein.

### TECHNICAL FIELD

The present disclosure relates to the field of display technology, and in particular to a quantum-dot light-emitting diode, a method for preparing the same, and a display device.

### BACKGROUND

Quantum-dot light-emitting diodes (QLED) have become a hot research direction of next-generation display technology due to their high color purity, high quantum efficiency, and adjustable color of light. The structure of the QLED generally includes a cathode, an electron transport layer, a light emitting layer, a hole transport layer, a hole injection layer, and an anode. However, the imbalance between the hole and electron transports often occur in QLED devices, and excess electrons tend to cause the annihilation of excitons, thereby degrading the performance of the QLED device.

### SUMMARY

According to one aspect of the present disclosure, a quantum-dot light-emitting diode is provided, in which at least a portion of the quantum-dot light-emitting layer of the quantum-dot light-emitting diode has an electron transport material.

Optionally, the quantum-dot light-emitting layer of the quantum-dot light-emitting diode is doped with the electron transport material.

Optionally, the quantum-dot light-emitting layer of the quantum-dot light-emitting diode includes a layer formed of the electron transport material proximate to a side of a hole transport layer.

Optionally, the layer formed of the electron transport material is configured to be a first electron transport layer.

Optionally, an energy difference between an HOMO energy level of a material of the hole transport layer and an HOMO energy level of the electron transport material is 0.4 eV or more.

Optionally, an energy difference between a LUMO energy level of a material of the hole transport layer and a LUMO energy level of the electron transport material is 0.4 eV or more.

Optionally, the first electron transport layer has a thickness of 3 nm or less.

Optionally, the material of the hole transport layer is at least one selected from a group consisting of poly[bis(4-phenyl)(4-butylphenyl)amine], polyvinyl carbazole, 4,4'-bis(N-carbazolyl)-1,1'-biphenyl, 4,4',4"-tris(carbazol-9-yl)-triphenylamine and 1,3-bis(carbazol-9-yl)benzene.

Optionally, the electron transport material is at least one selected from a group consisting of 4,6-bis(3,5-di(pyridin-3-yl)phenyl)-2-methylpyrimidine and (1,3,5-triazine-2,4,6-substituted)tris(phenyl-3,1-substituted)tris(diphenylphosphine oxide).

Optionally, a material of the quantum-dot light-emitting layer is a compound formed of a group IIB element and a group VA element, a composition composed of at least two compounds formed of the group IIB element and the group VA element, a compound formed of a group IIIB element and the group VA element, a core-shell structured composition composed of at least two compounds formed of the group IIIB element and the group VA element, a compound formed of a group IVB element and a group VIA element, or a core-shell structured composition composed of at least two compounds formed of the group IVB element and the group VIA element.

Optionally, the quantum-dot light-emitting diode includes an anode, a hole injection layer, a hole transport layer, a first electron transport layer, a quantum-dot light-emitting layer, a second electron transport layer and a cathode, which are stacked in sequence.

Optionally, the quantum-dot light-emitting diode includes an anode, a hole injection layer, a hole transport layer, a quantum-dot light-emitting layer, a second electron transport layer and a cathode, which are stacked.

Optionally, a material of the second electron transport layer is at least one selected from a group consisting of ZnO, TiO₂, AlZnO, ZnSnO and InSnO.

Optionally, the hole transport layer includes a first hole transport sublayer composed of a first hole transport material and a second hole transport sublayer composed of a second hole transport material, with the second hole transport sublayer being arranged on a side of the first hole transport sublayer proximate to the quantum-dot light-emitting layer, and with an HOMO energy level of the second sub-hole transport layer material being less than an HOMO energy level of the first sub-hole transport layer material.

According to another aspect of the present disclosure, a method for preparing a quantum-dot light-emitting diode is provided, including: depositing an anode on a substrate; forming a hole injection layer on the anode; forming a hole transport layer on the hole injection layer; forming a quantum-dot light-emitting layer on the hole transport layer, in which at least a portion of the quantum-dot light-emitting layer has an electron transport material; forming a second electron transport layer on the quantum-dot light-emitting layer; and forming a cathode.

Optionally, the quantum-dot light-emitting layer is doped with the electron transport material.

Optionally, the step of forming the quantum-dot light-emitting layer on the hole transport layer includes: forming a first electron transport layer on the hole transport layer of the quantum-dot light-emitting diode; and forming a quantum-dot light-emitting layer on the first electron transport layer.

Optionally, the hole transport layer includes a first hole transport sublayer and a second hole transport sublayer, which are in contact with each other.

According to one still another aspect of the present disclosure, a display device is also provided, including the quantum-dot light-emitting diode of any of the above aspects.

### BRIEF DESCRIPTION OF THE DRAWINGS

Fig. 1 is a schematic view showing energy levels of a quantum-dot light-emitting diode according to a first example of the related art.
Fig. 2 is a schematic view showing energy levels of a quantum-dot light-emitting diode according to a second example of the related art.
Fig. 3 is a schematic view showing a quantum-dot light-emitting diode according to one embodiment of the present disclosure.
Fig. 4 is a schematic view showing a quantum-dot light-emitting diode according to another embodiment of the present disclosure.
Fig. 5 is a schematic view showing the energy levels of the quantum-dot light-emitting diodes prepared in Example 1 of the present disclosure.
Fig. 6 is a schematic view showing the energy levels of the quantum-dot light-emitting diodes prepared in Example 2 of the present disclosure.

### DETAILED DESCRIPTION

In order to further understand the present disclosure, the optional embodiments of the present disclosure will be described below in conjunction with Examples, but it should be understood that these descriptions are merely used to further illustrate the features and advantages of the present disclosure and are not intended to limit the protection scope of the present disclosure.

The structure of quantum-dot light-emitting diodes (QLED) is quite special because the energy level structure of quantum-dot (QD) materials is not well matched to organic light-emitting diode (OLED) materials and ITO electrodes. The ionization potential of QD is usually relative large, generally greater than 6.0 eV. The ionization potentials of blue and green QD materials are even greater than 6.5 eV, while the work function of ITO electrode is only 4.7 eV. The ionization potential of conventional hole transport material is less than 5.5 eV. Therefore, the hole injection from the hole transport material to the QD light-emitting layer is relative difficult. On the contrary, the electron affinity of the QD material is usually around 4.0 eV, and the electronic affinity of the electron transport layer ZnO is also 4.0 eV, so it is easy to realize electron injection and transport. Such structure results in an imbalance between holes and electrons in the QLED.

In view of the problem of the imbalance between holes and electrons in QLED, the related art uses a hole transport layer having a multilayer, or insert an ultra-thin insulating layer between the electron transport and QD light-emitting layers at a same time. The use of the hole transport layer having a multilayer can divide a larger hole injection barrier into a plurality of smaller hole injection barriers, thereby improving the hole injection. Inserting an ultra-thin insulating layer between the electron transport and QD light-emitting layers may reduce the electron injection. The balance of the carrier injection can be achieved with either or both of these.

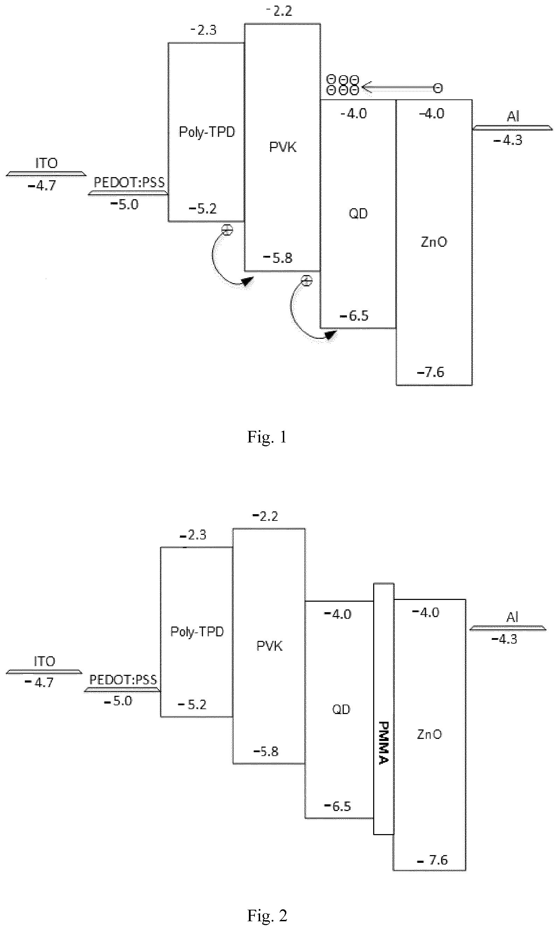

Fig. 1 is a schematic diagram showing energy levels of a quantum-dot light-emitting diode in the related art. The structure of the quantum-dot light-emitting diode in the related art includes an anode, a hole injection layer, a first hole transport sublayer, a second hole transport sublayer, a quantum-dot light-emitting layer, an electron transport layer, and a cathode. The anode may employ indium tin oxide (ITO), and the hole injection layer may employ poly(3,4-ethylenedioxythiophene)/poly(styrenesulfonate) (PEDOT:PSS), the first hole transport sublayer may employ poly[bis(4-phenyl)(4-butylphenyl)amine] (Poly-TPD), the second hole transport sublayer may employ poly(9-vinylcarbazole) (PVK), the electron transport layer may employ ZnO, and the anode may employ aluminum. The quantum-dot light-emitting diode in the related art may employs a hole transport layer having a multilayer, to divide a larger hole injection barrier into a plurality of smaller hole injection barriers.

Fig. 2 is a schematic diagram showing energy levels of a quantum-dot light-emitting diode in the related art. The structure of the quantum-dot light-emitting diode in the related art includes an anode, a hole injection layer, a first hole transport sublayer, a second hole transport sublayer, a quantum-dot light-emitting layer, an insulation layer, an electron transport layer, and a cathode. The anode may employ indium tin oxide (ITO), the hole injection layer may employ PEDOT:PSS, the first hole transport sublayer may employ poly[bis(4-phenyl)(4-butylphenyl)amine] (Poly -TPD), the second hole transport sublayer may employ poly(9-vinylcarbazole) (PVK), the insulating layer may employ polymethyl methacrylate (PMMA), the electron transport layer may employ ZnO, and the anode may employ aluminum. In the related art, an ultra-thin insulating layer PMMA is inserted between the electron transport and the QD light-emitting layer of the quantum-dot light-emitting diode to reduce the injection of electrons, thereby achieving the purpose of balancing carrier injection.

However, both the above-mentioned hole transport layer having a multilayer and one insulating layer inserted between the electron transport and the QD light-emitting layer leads to a relatively high driving voltage of the device. Moreover, electrons are accumulated at the interface between the hole transport layer and the QD light-emitting layer, and excess electrons tend to the annihilation of excitons, thereby degrading the performance of the device.

In this regard, the present disclosure proposes an improvement in that at least a portion of the quantum-dot light-emitting layer of the quantum-dot light-emitting diode has an electron transport material. In an optional embodiment, the quantum-dot light-emitting layer of the quantum-dot light-emitting diode includes a first electron transport layer formed of an electron transport material proximate to a side of the hole transport layer; and/or the quantum-dot light-emitting layer of the quantum-dot light-emitting diode is doped with an electron transport material. Since the quantum-dot light-emitting layer includes a layer formed of an electron transport material on a side proximate to the hole transport layer or the quantum-dot light-emitting layer is doped with an electron transport material, holes do not need to be injected into the quantum-dot light-emitting layer, instead, holes and electrons recombine to form an exciplex between the electron transport layer and the hole transport layer or between the hole transport layer and the quantum-dot light-emitting layer. The exciplex transports energy to the quantum-dot light-emitting layer, thereby avoiding the injection barrier from the hole transport layer to the quantum-dot light-emitting layer, and enhances the injection of holes; and increasing the potential barrier of the electron injection and reducing the number of the electrons injected at the same time. Therefore, the carrier injection is more balanced. In addition, the formed exciplex has a relative small energy level difference of triplet state (ΔEST), and the anti-intersystem crossing process from the triplet state to the singlet state can be realized at room temperature. The transportation of energy from the singlet state to the quantum-dot light-emitting layer emits light, so that the energy of the exciton can be better utilized, thereby improving the performance of the quantum-dot light-emitting diodes. For example, the improvement includes reducing the driving voltage, improving the light-emitting efficiency, extending the service life, and the like.

Therefore, the technical problem to be solved by the present disclosure is to provide a quantum-dot light-emitting diode, a method for preparing the same, and a display device. The quantum-dot light-emitting diode forms an exciplex between the electron transport layer and the hole transport layer or between the hole transport layer and the quantum-dot light-emitting layer. The exciplex transported energy to the quantum dots for emitting light, reduces the injection potential barrier of holes from the hole transport layer to the quantum-dot light-emitting layer, and makes the carrier injection more balanced, thereby improving the performance of the quantum-dot light-emitting diode.

According to one aspect of the present disclosure, a quantum-dot light-emitting diode is provided, in which at least a portion of the quantum-dot light-emitting layer of the quantum-dot light-emitting diode has an electron transport material. It will be appreciated that the "at least a portion of the quantum-dot light-emitting layer" described herein may be a part of the interior of the quantum-dot light-emitting layer or a part of the surface of the quantum-dot light-emitting layer. Therefore, "at least a portion of the quantum-dot light-emitting layer of the quantum-dot light-emitting diode has an electron transport material" includes the following situations: (1) there is an electron transport material inside the quantum-dot light-emitting layer, in which the electron transport material may be uniformly distributed or randomly distributed in the entire region or partial region of the quantum-dot light-emitting layer, or optionally uniformly distributed in the quantum-dot light-emitting layer; and (2) the electron transport material is distributed on the surface of the quantum-dot light-emitting layer and is in contact with the quantum-dot light-emitting layer, and the electron transport material can be uniformly distributed on the surface of the quantum-dot light-emitting layer and form a continuous layer or a discontinuous island-like distribution. Optionally, the electron transport material is uniformly distributed on the surface of the quantum-dot light-emitting layer and forms a uniform layer.

Optionally, the quantum-dot light-emitting layer of the quantum-dot light-emitting diode is doped with an electron transport material.

Optionally, the quantum-dot light-emitting layer of the quantum-dot light-emitting diode includes a layer formed of the electron transport material proximate to a side of a hole transport layer.

In the present disclosure, the first electron transport layer is in contact with the hole transport layer or the electron transport material is in contact with the hole transport layer. Optionally, the energy levels of the materials of the hole transport layer, the first electron transport layer, and the quantum-dot light-emitting layer match with each other, to ensure that holes and electrons are transported among them. Optionally, the energy difference between the HOMO energy level of the material of the hole transport layer and the HOMO energy level of the electron transport material is greater than the energy level of the quantum dots. Optionally, the energy difference between the LUMO energy level of the material of the hole transport layer and the LUMO energy level of the material of the electron transport layer is greater than the energy level of the quantum dots. For example, an energy difference between an HOMO energy level of a material of the hole transport layer and an HOMO energy level of the electron transport material is 0.4 eV or more. Optionally, for example, an energy difference between a LUMO energy level of a material of the hole transport layer and a LUMO energy level of the electron transport material is 0.4 eV or more.

When a first electron transport layer formed of an electron transport material is arranged on a side of the quantum-dot light-emitting layer proximate to the hole transport layer, holes and electrons form an exciplex between the first electron transport layer and the hole transport layer, in which the energy of the exciplex is the difference between the HOMO of the material of the hole transport layer and the LUMO of the electron transport material. When the quantum-dot light-emitting layer of the quantum-dot light-emitting diode is doped with an electron transport material, holes and electrons form an exciplex between the hole transport layer and the quantum-dot light-emitting layer. The exciplex transports energy to the quantum-dot light-emitting layer, to achieve the light emitting of the quantum dot organic light-emitting diode.

In the Foster energy theory, the rate constant of energy transport is inversely proportional to the sixth power of the donor-acceptor distance, i.e., the smaller the distance between the donor and the acceptor, the higher the energy transport rate. For the quantum dot organic light-emitting diode of the present disclosure, the smaller the distance between the hole transport layer and the quantum-dot light-emitting layer, the higher the energy transport speed. Therefore, when the quantum-dot light-emitting layer of the quantum-dot light-emitting diode of the present disclosure is doped with an electron transport material, more efficient energy transport can be achieved. When the first electron transport layer formed of the electron transport material is provided on the side of the quantum-dot light-emitting layer in the present disclosure proximate to the hole transport layer, the thickness of the first electron transport layer is set as small as possible. Optionally, the thickness of the first electron transport layer may be 5 nm or less, or may be 3 nm or less. Optionally, the thickness of the first electron transport layer may be 0.2 nm or less, or even may be 0.5 nm or less.

In the present disclosure, the electron transport material may be at least one selected from a group consisting of ZnO, TiO₂, AlZnO, ZnSnO, and InSnO, and may also be at least one selected from a group consisting of 4,6-bis(3,5-di(pyridin-3-yl)phenyl)-2-methylpyrimidine (B3PYMPM) and (1,3,5-triazine-2,4,6-substituted)tris(phenyl-3,1-substituted))tris(diphenylphosphine oxide). From the aspect of obtaining a better energy level matching effect, the electron transport material constituting the first electron transport layer may be at least one selected from 4,6-bis(3,5-di(pyridin-3-yl)phenyl)-2-methylpyrimidine (B3PYMPM) and (1,3,5-triazine-2,4,6-substituted)tris(phenyl-3,1-substituted))tris (diphenylphosphine oxide).

The structural formula of 4,6-bis(3,5-di(pyridin-3-yl)phenyl)-2-methylpyrimidine (B3PYMPM) is:

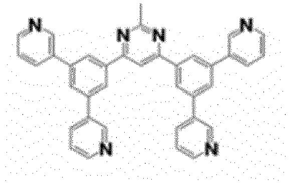

Optionally, the material of the hole transport layer may be at least one selected from a group consisting of poly[bis(4-phenyl)(4-butylphenyl)amine] (Poly-TPD), polyvinyl carbazole (PVK), 4,4'-bis(N-carbazolyl)-1,1'-biphenyl (CBP), 4,4',4"-tris(carbazol-9-yl)-triphenylamine (TCTA) and 1,3-bis(carbazol-9-yl)benzene (mCP). For example, the first hole transport material may be poly[bis(4-phenyl)(4-butylphenyl)amine] (Poly-TPD), and the second hole transport material may be poly(9-vinylcarbazole) (PVK), and vice versa.

The structural formula of poly[bis(4-phenyl)(4-butylphenyl)amine] (Poly-TPD) is:

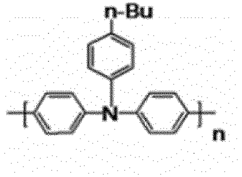

The structural formula of poly(9-vinylcarbazole) (PVK) is:

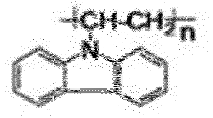

Optionally, the material of the quantum-dot light-emitting layer may be a material selected from a group consisting of a compound formed of a group IIB element and a group VA element, a composition composed of at least two compounds formed of the group IIB element and the group VA element, a compound formed of a group IIIB element and the group VA element, a core-shell structured composition composed of at least two compounds formed of the group IIIB element and the group VA element, a compound formed of a group IVB element and a group VIA element, and a core-shell structured composition composed of at least two compounds formed of the group IVB element and the group VIA element. The material of the quantum-dot light-emitting layer specifically includes, but is not limited to, one of a group consisting of CdS, CdSe, CdS/ZnS, CdSe/ZnS, CdSe/CdS/ZnS, GaAs, InP, PbS/ZnS, and PbSe/ZnS.

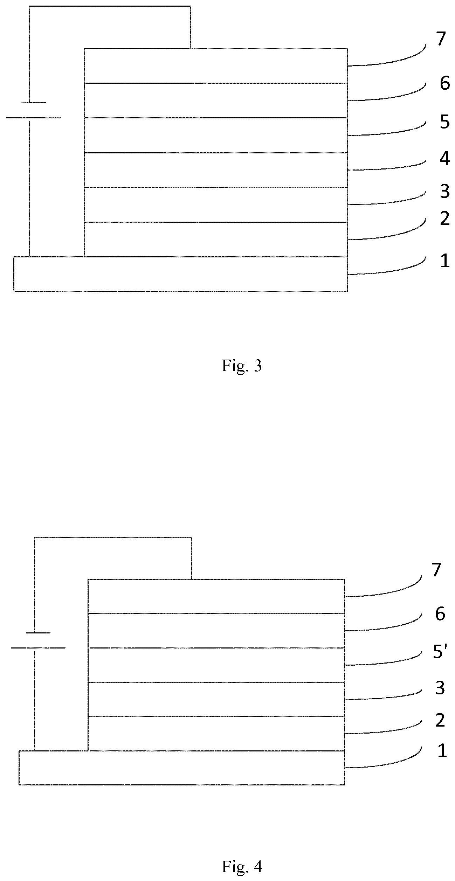

Fig. 3 is a schematic view showing a quantum-dot light-emitting diode according to one embodiment of the present disclosure. Referring specifically to Fig. 3, the quantum-dot light-emitting diode specifically includes an anode 1, a hole injection layer 2, a hole transport layer 3, a first electron transport layer 4, a quantum-dot light-emitting layer 5, a second electron transport layer 6, and a cathode 7, which are stacked.

Fig. 4 is a schematic view showing a quantum-dot light-emitting diode according to another embodiment of the present disclosure. Referring specifically to Fig. 4, the quantum-dot light-emitting diode specifically includes an anode 1, a hole injection layer 2, the hole transport layer 3, the quantum-dot light-emitting layer 5', the second electron transport layer 6, and the cathode 7, which are stacked. The quantum-dot light-emitting layer 5' is doped with an electron transport material. Optionally, the electron transport material doped into the quantum-dot light-emitting layer 5' may be at least one selected from a group consisting of 4,6-bis(3,5-di(pyridin-3-yl)phenyl)-2-methylpyrimidine (B3PYMPM) and (1,3,5-triazine-2,4,6-substituted)tris(phenyl-3,1-substituted))tris(diphenylphosphine oxide).

Optionally, the material of the second electron transport layer includes at least one of ZnO, TiO₂, AlZnO, ZnSnO, and InSnO.

Optionally, the present disclosure can further improve the injection of holes by providing two layers of hole transport layers to divide a hole injection barrier into a plurality of smaller hole injection barriers. Optionally, the hole transport layer includes a first hole transport sublayer composed of a first hole transport material and a second hole transport sublayer composed of a second hole transport material, with the second hole transport sublayer being arranged on a side of the first hole transport sublayer proximate to the quantum-dot light-emitting layer.

Optionally, an HOMO energy level of the second hole transport material is less than an HOMO energy level of the first hole transport material. Further optionally, the HOMO energy level difference between the second hole transport material and the quantum-dot material is ≤0.2 eV. The HOMO energy level of the second hole transport material is higher than the triplet state energy level ET of the quantum-dot material.

According to another aspect of the present disclosure, a method for preparing a quantum-dot light-emitting diode is provided, including: depositing an anode on a substrate; forming a hole injection layer on the anode; forming a hole transport layer on the hole injection layer; forming a quantum-dot light-emitting layer on the hole transport layer, in which at least a portion of the quantum-dot light-emitting layer has an electron transport material; forming a second electron transport layer on the quantum-dot light-emitting layer; and forming a cathode.

Optionally, the quantum-dot light-emitting layer is doped with the electron transport material.

Optionally, the step of forming the quantum-dot light-emitting layer on the hole transport layer includes: forming a first electron transport layer on the hole transport layer of the quantum-dot light-emitting diode; and forming a quantum-dot light-emitting layer on the first electron transport layer.

In one embodiment of the present disclosure, when the quantum-dot light-emitting diode includes a anode, a hole injection layer, a hole transport layer, a first electron transport layer, a quantum-dot light-emitting layer, a second electron transport layer and a cathode, which are stacked, the method for preparing the quantum-dot light-emitting diode specifically includes: depositing an anode on a substrate; forming a hole injection layer on the anode; forming a hole transport layer on the hole injection layer; forming a first electron transport layer on the hole transport layer; forming a quantum-dot light-emitting layer on the first electron transport layer; forming a second electron transport layer on the quantum-dot light-emitting layer; and forming a cathode.

In one embodiment of the present disclosure, when the quantum-dot light-emitting diode includes a anode, a hole injection layer, a hole transport layer, a quantum-dot light-emitting layer, and a second electron transport layer, which are stacked, the method for preparing the quantum-dot light-emitting diode specifically includes: depositing an anode on a substrate; forming a hole injection layer on the anode; forming a hole transport layer on the hole injection layer; forming a quantum-dot light-emitting layer on the hole transport layer, in which the quantum-dot light-emitting layer includes quantum dots and a doped electron transport material; forming a second electron transport layer on the quantum-dot light-emitting layer; and forming a cathode.

Optionally, the hole transport layer includes a first hole transport sublayer and a second hole transport sublayer that are in contact with each other, and the preparation method specifically includes: forming a first electron transport layer on a side of the second hole transport sublayer away from the first hole transport sublayer.

Optionally, the hole transport layer includes a first hole transport sublayer and a second hole transport sublayer, which are in contact with each other.

According to one still another embodiment of the present disclosure, a display device is disclosed, including the quantum-dot light-emitting diode described in the above technical solution.

The display device may be a display substrate or a display device. The display device, for example, may include any product or component having a display function, such as a television, a display, a digital photo frame, a mobile phone, and a tablet computer.

### EXAMPLES

In order to further understand the present disclosure, the quantum-dot light-emitting diode, the method for preparing the same, and the display device provided by the present disclosure will be described detailedly in the following specific Examples, but the protection scope of the present disclosure is not limited by the following specific Examples.

### Example 1

A substrate was provided, on which an ITO anode was prepared; the ITO anode is sequentially washed with acetone, isopropyl alcohol, detergent, deionized water and isopropanol, and an O₂ plasma treatment or UV ozone cleaning treatment was performed after drying. On the ITO anode, a hole injecting layer of a PEDOT:PSS material was prepared by a solution or an vapor deposition method. A first hole transport sublayer made of poly-TPD and a second hole transport sublayer made of PVK were formed by a solution or vapor deposition method. The first electron transport layer of B3PYMPM was formed by a solution or vapor deposition method, in which the thickness of the first electron transport layer is less than 3 nm. A quantum-dot light-emitting layer was prepared by a solution method. A second electron transport layer of ZnO was formed by a solution or vapor deposition method. An Al electrode was formed by vapor deposition to obtain a quantum-dot light-emitting diode.

The performance of the quantum-dot light-emitting diode prepared in Example 1 was tested, and the test results were shown in Table 1.

**Table 1**

| | Turn-on Voltage (V) | Voltage @100 nits (V) | Maximum current efficiency (cd/V) | Current efficiency @ 100 mA/cm² (cd/A) |
|---|---|---|---|---|
| Example 1 | 2.3 | 3.7 | 3.5 | 3.3 |
| Related Art 1 | 2.5 | 4.0 | 2.0 | 1.8 |

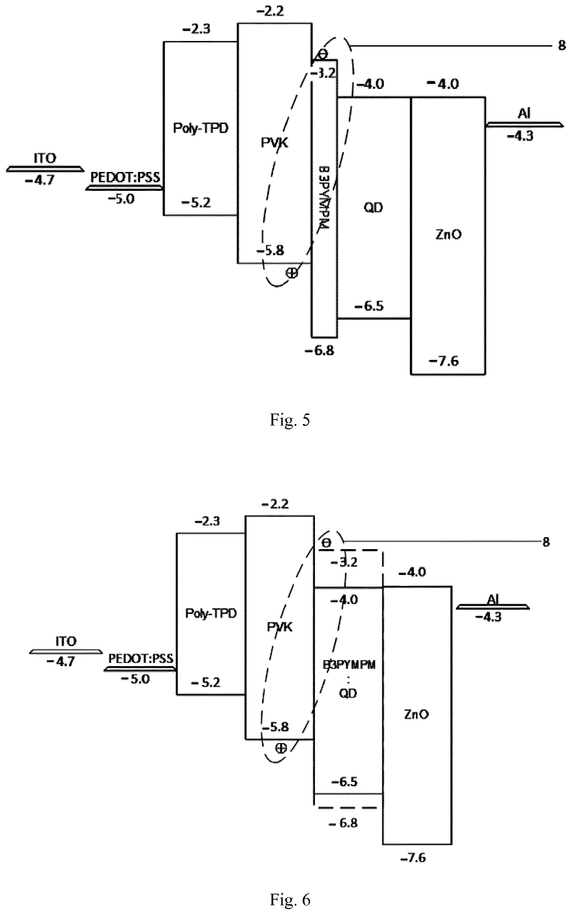

Fig. 5 is a schematic view showing the energy levels of the quantum-dot light-emitting diodes prepared in Example 1. In Fig. 5, reference number 8 is a portion where holes and electrons form an exciplex, that is, a region enclosed by the dashed box. The exciplex is formed between the second hole injection sublayer and the first electron transport layer, thereby avoiding the injection barrier from the hole transport layer to the quantum-dot light-emitting layer and enhancing the injection of holes; and increasing the potential barrier of the electron injection and reducing the number of the electrons injected at the same time. Therefore, the carrier injection of the quantum-dot light-emitting diode is more balanced.

Since the HOMO level of B3PYMPM is relatively deep (6.8 eV) and holes are difficult to be injected, so that holes and electrons recombined to form an exciplex in the region shown by reference number 8. Thereafter, the exciplex then transported energy to the QD by means of energy transport, thereby emitting light. As can be seen from the results tested in Table 1, as compared with the related art in Fig. 1, the hole injection lacks one potential barrier and the electron injection has one more potential barrier in this Example, so that the situation of having more holes and less electrons in the related art is improved, thereby making the carrier transport more balanced and improving the performance of QLED.

### Example 2

A substrate was provided, on which an ITO anode was prepared; the ITO anode is sequentially washed with acetone, isopropyl alcohol, detergent, deionized water and isopropanol, and an O₂ plasma treatment or UV ozone cleaning treatment was performed after drying. On the ITO anode, a hole injecting layer of a PEDOT:PSS material was prepared by a solution or an vapor deposition method. A first hole transport sublayer made of poly-TPD and a second hole transport sublayer made of PVK were formed by a solution or vapor deposition method. The B3PYMPM and the quantum dots were respectively dissolved in a same or different organic solvent and then mixed, and a quantum-dot light-emitting layer was prepared by a solution method. A second electron transport layer of ZnO was formed by a solution or vapor deposition method. An Al electrode was formed by vapor deposition to obtain a quantum-dot light-emitting diode.

The performance of the quantum-dot light-emitting diode prepared in Example 2 was tested, and the test results were shown in Table 2.

**Table 2**

| | Turn-on Voltage (V) | Voltage @100 nits (V) | Maximum current efficiency (cd/V) | Current efficiency @ 100 mA/cm² (cd/A) |
|---|---|---|---|---|
| Example 2 | 2.3 | 3.6 | 3.4 | 3.1 |
| Related Art 1 | 2.5 | 4.0 | 2.0 | 1.8 |

Fig. 6 is a schematic view showing the energy levels of the quantum-dot light-emitting diodes prepared in Example 2. In Fig. 6, reference number 8 is a portion where holes and electrons form an exciplex. The exciplex is formed between the second hole injection sublayer and the quantum-dot light-emitting layer, thereby avoiding the injection barrier from the hole transport layer to the quantum-dot light-emitting layer, and enhancing the injection of holes; and increasing the potential barrier of the electron injection and reducing the number of the electrons injected at the same time. Therefore, the carrier injection is more balanced.

The description of the above Examples is merely used for helping to understand the preparation method according to the present disclosure and its inventive concept. It should be noted that a person skilled in the art may make further improvements and modifications to the disclosure without departing from the principle/spirit of the present disclosure, and these improvements and modifications shall also fall within the scope of the present disclosure. Therefore, the present disclosure will not be limited to the Examples shown herein, but should conform to the widest scope consistent with the principles and novel features disclosed herein.

## Claims

1. A quantum-dot light-emitting diode, wherein at least a portion of a quantum-dot light-emitting layer of the quantum-dot light-emitting diode has an electron transport material.

2. The quantum-dot light-emitting diode of claim 1, wherein the quantum-dot light-emitting layer is doped with the electron transport material.

3. The quantum-dot light-emitting diode of claim 1 or 2, wherein the quantum-dot light-emitting layer of the quantum-dot light-emitting diode comprises a layer formed of the electron transport material proximate to a side of a hole transport layer, and the layer formed of the electron transport material is configured to be used as a first electron transport layer.

4. The quantum-dot light-emitting diode of claim 3, wherein an energy difference between an HOMO energy level of a material of the hole transport layer and an HOMO energy level of the electron transport material is about 0.4 eV or more.

5. The quantum-dot light-emitting diode of claim 3, wherein an energy difference between an LUMO energy level of a material of the hole transport layer and an LUMO energy level of the electron transport material is about 0.4 eV or more.

6. The quantum-dot light-emitting diode of claim 4 or 5, wherein the first electron transport layer has a thickness of about 3 nm or less.

7. The quantum-dot light-emitting diode of any one of claims 3 to 6, wherein the material of the hole transport layer is at least one selected from a group consisting of poly[bis(4-phenyl)(4-butylphenyl)amine], polyvinyl carbazole, 4,4'-bis(N-carbazolyl)-1,1'-biphenyl, 4,4',4"-tris(carbazol-9-yl)-triphenylamine and 1,3-bis(carbazol-9-yl)benzene.

8. The quantum-dot light-emitting diode of any one of claims 1 to 3, wherein the electron transport material is at least one selected from a group consisting of 4,6-bis(3,5-di(pyridin-3-yl)phenyl)-2-methylpyrimidine and (1,3,5-triazine-2,4,6-substituted)tris(phenyl-3,1-substituted)tris(diphenylphosphine oxide).

9. The quantum-dot light-emitting diode of any one of claims 1 to 7, wherein a material of the quantum-dot light-emitting layer is a compound formed of a group IIB element and a group VA element, a composition composed of at least two compounds formed of the group IIB element and the group VA element, a compound formed of a group IIIB element and the group VA element, a core-shell structured composition composed of at least two compounds formed of the group IIIB element and the group VA element, a compound formed of a group IVB element and a group VIA element, or a core-shell structured composition composed of at least two compounds formed of the group IVB element and the group VIA element.

10. The quantum-dot light-emitting diode of claim 1 or 2, wherein the quantum-dot light-emitting diode comprises an anode, a hole injection layer, the hole transport layer, the quantum-dot light-emitting layer, a second electron transport layer and a cathode, which are stacked.

11. The quantum-dot light-emitting diode of claim 10, wherein a material of the second electron transport layer is at least one selected from a group consisting of ZnO, TiO₂, AlZnO, ZnSnO and InSnO.

12. The quantum-dot light-emitting diode of claim 10 or 11, wherein the hole transport layer comprises a first hole transport sublayer composed of a first hole transport material and a second hole transport sublayer composed of a second hole transport material, with the second hole transport sublayer being arranged on a side of the first hole transport sublayer proximate to the quantum-dot light-emitting layer, and with an HOMO energy level of the second hole transport layer material being less than an HOMO energy level of the first hole transport material.

13. A method for preparing a quantum-dot light-emitting diode, comprising: depositing an anode on a substrate; forming a hole injection layer on the anode; forming a hole transport layer on the hole injection layer; forming a quantum-dot light-emitting layer on the hole transport layer, wherein at least a portion of the quantum-dot light-emitting layer has an electron transport material; forming a second electron transport layer on the quantum-dot light-emitting layer; and forming a cathode.

14. The method of claim 13, wherein the quantum-dot light-emitting layer is doped with the electron transport material.

15. The method of claim 13 or 14, wherein the hole transport layer comprises a first hole transport sublayer and a second hole transport sublayer, which are in contact with each other.

16. A display device comprising the quantum-dot light-emitting diode of any one of claims 1 to 12.
